# EUROPEAN PATENT APPLICATION

(11) **EP 1 521 360 A1**
(43) Date of publication of application: **06.04.2005**
(21) Application number: 03022323.4
(22) Date of filing: 04.10.2003
(51) Int. Cl.: H03F 1/02, H03F 3/21, H03F 3/72

(54) **Parallel amplifier arrangement**

(71) Applicant: Lucent Technologies Network Systems GmbH, 90411 Nürnberg (DE)
(72) Inventor: Eckl, Wolfgang Franz, Dr., 91080 Spardorf (DE); Fischer, Georg, Dr., 90419 Nürnberg (DE); Friedel, Bernd Georg, 91477 Markt Bibart (DE)
(74) Representative: Blumbach Zinngrebe

(57) **Abstract**

An amplifier arrangement comprising signal input means (3), a first amplifying device (1), at least a second amplifying device (2), and a signal output means (4). The signal input means (3) splits and/or conditions any incoming signal into at least a first branch (11) and a second branch (12), and includes at least one reconfigurable circuit (31, 32, 36) to said first and second amplifying devices (1, 2). The said signal output means (4) combines any signal output and includes at least one reconfigurable circuit (33, 34, 35). Furthermore, control means (5) for said reconfigurable circuits (31 through 36) is provided for controlling said reconfigurable circuits individually and independently from one another.

## Description

### Field of the Invention

The invention relates to an amplifier arrangement comprising at least two parallel amplifiers with the features of the preamble to claim 1.

### Background of the Invention

Parallel power amplifiers consist of at least two active devices that operate in parallel. Therefore special splitting networks are necessary at the input of the parallel amplifier, and special combining networks are necessary at the output of the parallel amplifier to get an overall amplifier with one input and one output (as for the single active device amplifier).

Parallel power amplifiers are mainly used for the following reasons:
To get an output power level not achievable with only one active device;
to increase the reliability of the whole amplifier (if one branch fails, then the whole amplifier still works, but with a lower output power level);
to optimize one or more performance parameters of the whole amplifier (e. g. improved input and output matching for the balanced design, lower influence of the active device's ground leads on the amplifier performance for the push-pull design, efficiency for the Doherty amplifier, ...)

In all of the parallel concepts, except for the Doherty amplifier, all active devices run all at time, even if an output power level is demanded that is below the amplifier maximum available output power. This leads to lower efficiencies for reduced output power levels. If one would be able to power off one or more branches of the parallel amplifier to adapt the output power capability of the parallel amplifier to the needed output power level, then the efficiency would raise again. But the main problem with powering off branches is that the input and output impedances seen by the still powered on active devices change and consequently the overall performance of the parallel amplifier would depend on the number of active cells. Additionally some of the parallel amplifier concepts (e. g. balanced amplifier) rely on the symmetry of the whole amplifier. By powering of branches this symmetry would be destroyed and additional losses would occur.

The Doherty amplifier is a special kind of parallel amplifier as it is designed to increase only the efficiency for reduced output power levels and not to increase output power capability or raise the amplifier's reliability. The problem with the change in input and output impedance seen by the still active device is solved by a special RF network that appropriately combines the outputs of both active devices.

### Summary of the Invention

It is an object of the invention to improve on parallel amplifiers arrangements, particularly in respect of gain, efficiency and output power capability.

The problem is solved by an amplifier arrangement having the features of claim 1. Further developments of the invention can be found in the features of the depending claims.

By placing a reconfigurable circuit at the input and the output of each active device of a parallel amplifier, one is able to compensate for the change in impedance caused by powering on or off one or more branches of the parallel amplifier. In this manner, the efficiency for reduced output power level can be raised by adapting the output power capability of the parallel amplifier to the needed level.

In a preferred embodiment, the active devices for the different branches of the parallel amplifier arrangement are implemented by a transistor array or one transistor with more than one RF input pins and one or more RF output pins. A ladder transistor may be formed which is divided in two or more sections, each having the same or a different number of pins or fingers. In this manner, more than one active and separate controllable device is obtained.

Further details of the invention will be apparent when studying the description of the preferred embodiments.

### Brief Description of the Drawings

- Fig. A: shows a schematic diagram of a push-pull amplifier,
- Fig. B: shows a schematic diagram of a balanced amplifier,
- Fig. C: shows a schematic diagram of a two-way power combining amplifier,
- Fig. D: shows a schematic diagram of a Doherty amplifier,
- Fig. 1: shows a first embodiment of a parallel amplifier according to invention,
- Fig. 2: shows a second embodiment of a parallel amplifier according to invention,
- Fig. 3: shows a third embodiment of a parallel amplifier according to invention,
- Fig. 4: shows a possible detail of the embodiment of Fig. 1,
- Fig. 5: shows a possible detail of the embodiment of Fig. 2 and
- Fig. 6: shows an efficiency diagram.

### Detailed Description

In order to better understand the problems underlying the invention, reference is made to Figs. A through D which show four examples of parallel amplifier concepts.

### 1) Push-Pull Amplifiers:

The input signal to a push-pull amplifier is split into an inphase (0°) and an antiphase (180°) part with both parts having equal amplitudes (ideal components assumed). This splitting process is achieved by the use of a 180°-balun. Both signal parts are amplified by two identical active devices. Each of them is packed in an extra housing and both are mounted on a common flange to get the highest degree of symmetry. This special transistor is a so-called push-pull transistor. It provides separate input and output pins for each active device. The two out-of-phase output signals of both active devices are combined by a second 180°-balun to get a single-ended output signal (constructive combining). Assuming no losses in the baluns, the combined output power is twice the output power of a single active device.

A schematic representation of the push-pull concept can be found in Figure A.

### 2) (Quadrature) Balanced Amplifier:

The input signal to a balanced amplifier is split into an inphase (0°) and a quadrature (90°) part with both parts having equal amplitudes (ideal components assumed). This splitting process is achieved by the use of a first 90°-hybrid. Both signal parts are amplified by two active devices. These two active devices may be two single separate transistors or a push-pull transistor. Important is to use identical active devices to achieve the highest possible degree of symmetry. Consequently, there is a separate input and an output pin for each active device. The two amplified signals of both active devices are combined by a second 90° hybrid to get the output signal. Assuming no losses in the baluns, the combined output power is twice the output power of a single active device.

A schematic representation of the balanced concept can be found in Figure B.

### 3) Power Combining:

The input signal to a power-combining amplifier is split into several (at least two) inphase (0°) parts with equal amplitudes (ideal splitters assumed). This splitting process is achieved by the use of n-way 0°-power splitters. Each signal part is amplified by a separate active device with separate input and output pin. Important is to use active devices with identical phase response. The gain of each active device may be different. The amplified signals of the active devices are combined by a 0° power combiner to generate the output signal. Assuming no losses in the splitters and combiners, the combined output power is the sum of the output powers of all individual active devices.

A schematic representation of the power-combining concept can be found in Figure C.

### 4) Doherty Amplifier:

Two amplifiers with a special combining network are used. The combining network ensures that both transistors are terminated with the correct impedances for the different output power levels. The amplifiers are called main amplifier and auxiliary amplifier. For output power levels close to the combined maximum output power of both transistors, both amplifiers are active. As the output power is reduced, the auxiliary amplifier shuts down (main is still active) at a certain level and generates no more RF power (the shut down is typically at 6 dB below maximum combined output power). For this power back off condition the main amplifier is near its maximum output power, thus the efficiency is almost at its optimum.

The Doherty concept is ideally suited for tube amplifiers. For solid state amplifiers there are some more constraints and requirements that impede the realization.

A schematic representation of the Doherty concept can be found in Figure D.

The effectiveness of the parallel amplifier concepts 1) and 2) depends on the symmetry and match of all active and passive devices, for concept 3) it depends on identical phase characteristics for each branch, and for concept 4) it depends on certain relationships between both active devices and on the combining network at the output.

All the mentioned concepts have their advantages and disadvantages which are not to be discussed here. Please refer to the literature, e. g. "RF Power Amplifiers for Wireless Communication" by Steve C. Cripps, Artech House Inc., ISBN 0-89006-989-1).

In all of the parallel amplifier concepts the branches are powered on all the time, even if one or more branches could be powered off due to reduced output power level. By doing so it is ensured that the active devices operate in a well-designed and fixed environment, means there is no change in input and output impedance seen by the active devices. So the main objectives for a parallel amplifier design, namely increased output power capability and higher reliability, can be met.
The only exception is the Doherty amplifier that solves the problem with the changed output impedance by a sophisticated RF output network and appropriate main and auxiliary active devices. The powering off and on of one amplifier branch, depending on the actual output power level, is included in the concept.

Thus, the following problems arise:
a) Power losses in the necessary combining and splitting networks at the input and the output of the whole amplifier.
b) Due to the power losses, a difference in gain, efficiency and output power capability for the whole amplifier is obtained compared to amplifiers based on single devices.
c) For concepts 1) and 2): The active devices have to be identical in all parameters, the passive networks at the amplifiers' input and output must have identical and symmetrical performance for concept 3): All branches of the whole amplifier must have identical phase characteristics. For concept 4) the main and auxiliary active device must meet certain requirements.
d) If one or more active devices are switched off, the efficiency worsens, and the amplifier's overall gain decreases (except for Doherty).
e) If one or more active devices are switched off, the overall performance of the parallel amplifier changes.
f) For Doherty: Extremely difficult to realize, so there is almost no practical benefit.
g) Problems due to the fixed networks at the inputs and outputs of the active devices: Fixed and limited frequency band of operation for the whole amplifier, effectiveness of the concepts depends on the component tolerances and symmetries.
h) Temperature and aging drifts worsen the performance of the whole parallel amplifier.

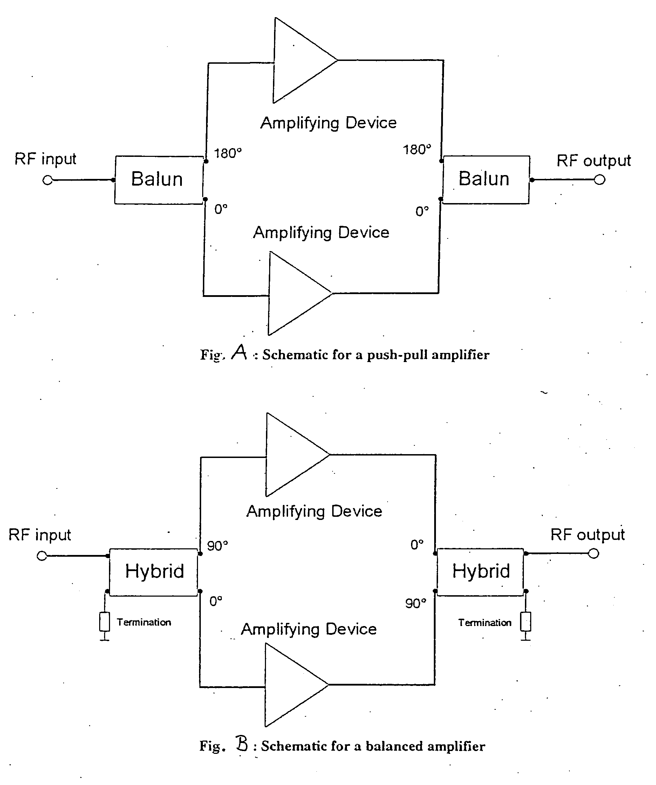

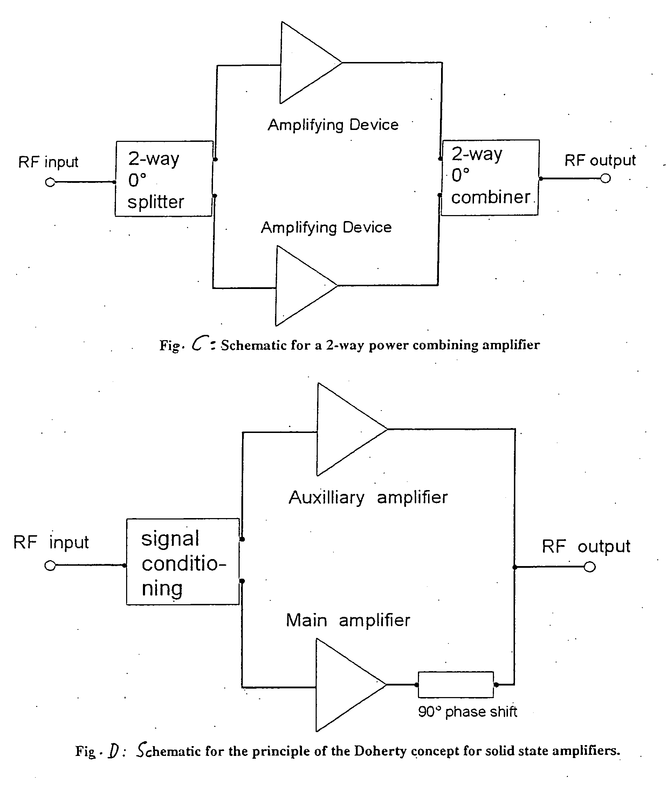

Parallel amplifiers according to the invention are shown in Figs. 1 through 3. Each of these parallel amplifier arrangements include a first amplifying device 1, a second amplifying device 2, a common signal input means 3, a common signal output means 4, control means 5 for reconfigurable circuits, bias control means 6, and operation control means 7. Furthermore, the signal input means 3 have at least two branches 11 and 12, and the signal output means 4 also include at least two branches 13 and 14. The bias control means 6 have lines 61 and 62 to control the gain of amplifiers 1 and 2, respectively, and may be implemented as DC bias control means. Control means 5 are adapted via control lines 51 through 56 to control reconfigurable circuits 31 through 36 which may be implemented by RF-MEMS switches and/or varactors or other similar techniques for altering RF characteristics, and generally by variable impedance transformers. A very important feature of the reconfigurable circuits is that they are adjustable electronically by software, that is, reconfiguration is done without the need of any manual action, such as manually retune trimmers. The feature allows compensation of temperature and aging drifts and also the use of adaptive systems. Such electronic access to the circuits also allows for remote changes in the context of a base station of a mobile communication system.

In the Fig. 1 embodiment, each branch 11 through 14 has its own reconfigurable circuit 31 through 34. This allows to fully compensate for any change in impedance caused by powering on or off one or more branches of the parallel amplifier arrangement. By adapting the output power capability of the parallel amplifier arrangement to the needed power level, the efficiency of the arrangement is raised for reduced output power levels. In relation to known parallel amplifier arrangements (Figs. A through D) power losses can be avoided which are caused by the splitting and combining networks in the arrangements of Figs. A through D.

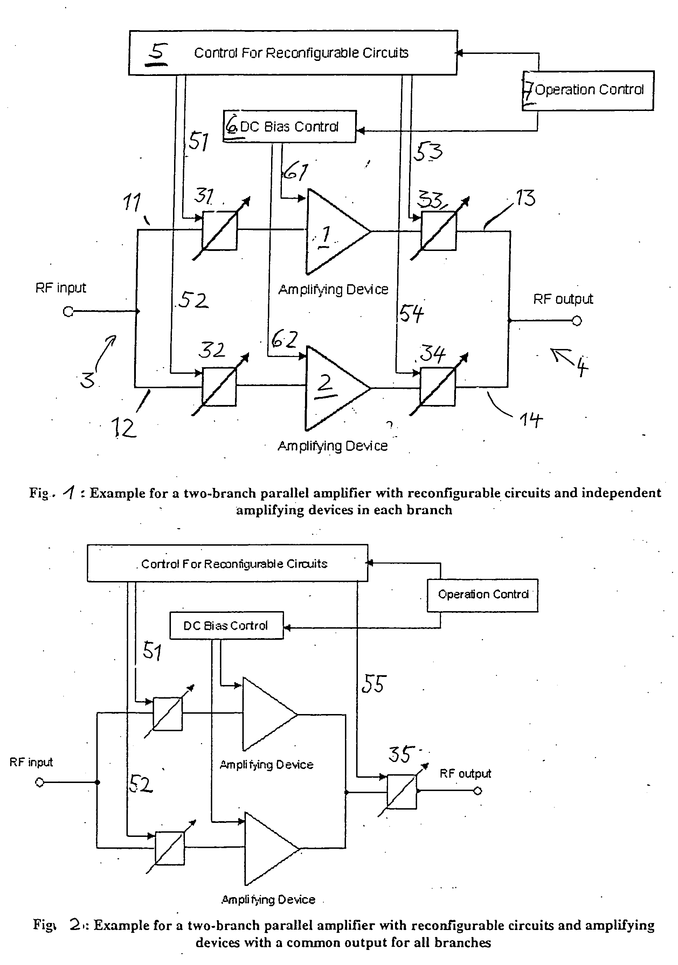

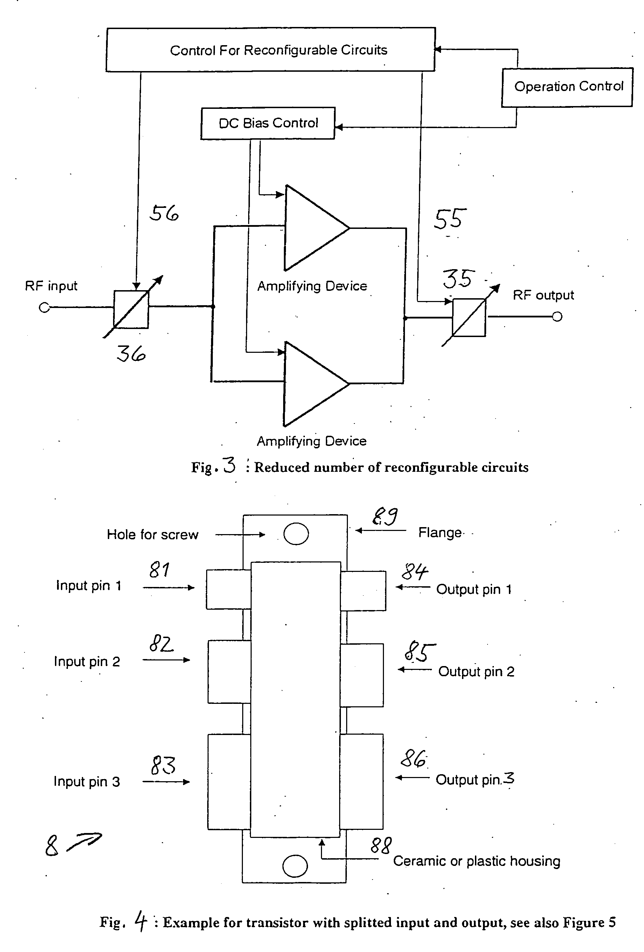

Fig. 2 is a simplified version of the embodiment of Fig. 1 in that the reconfigurable circuits 33 and 34 are unified to form a single circuit 35. Fig. 3 shows a still further simplified embodiment wherein the reconfigurable circuit 31 and 32 has been unified to form a single component 36.

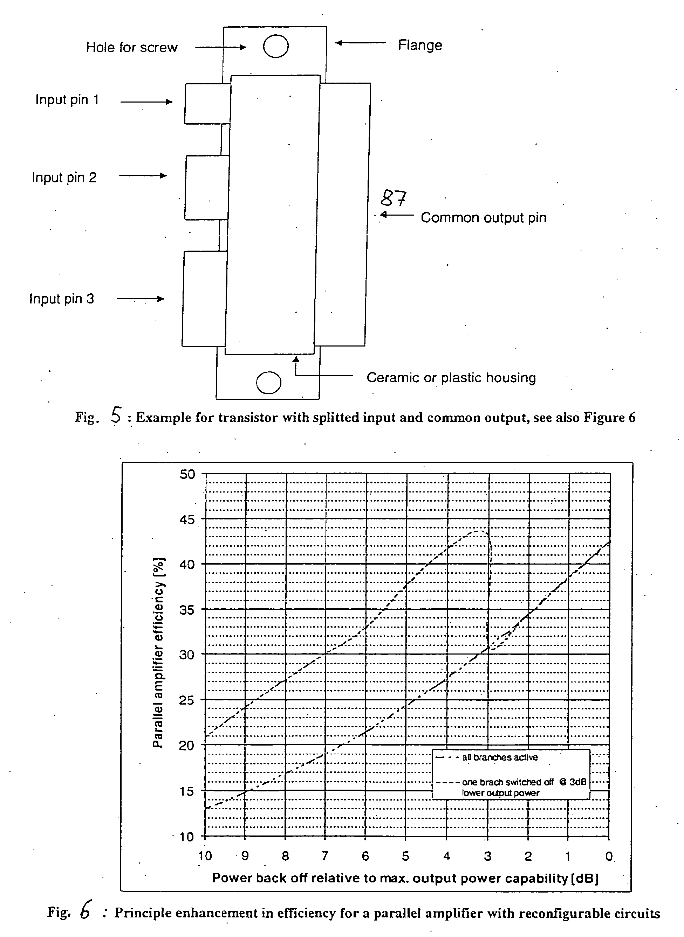

The active devices of the different branches can be realized or implemented by several single packaged transistors, by a transistor array or by a ladder transistor as shown in Figs. 4 and 5. The ladder transistor 8 has input pins 81, 82, 83 and output pins 84, 85, 86 (Fig. 4) or a common output pin 87 (Fig. 5). The transistor 8 itself is protected in a ceramic or plastic housing 88 fixed to a flange 89 which can be attached to any board, as is well known. As shown, the transistor as such is divided in several sections with the same or a different number of pins or fingers to get more than one active and separate controllable device. This allows to adapt the output power capability of the transistor to the needed capability which will increase the efficiency of the transistor and therefore also of the parallel amplifier. The concept shown allows to build and use a multi-input and/or output transistor having different numbers of pins or fingers per active device and therefore can be designed to fit the defined output power characteristics or an application in question. The concept can be used to make the output power of a parallel amplifier arrangement scaleable.

The reconfigurable circuits 31 through 36 at the input or output of each active device 1, 2 or 8 can also be used to optimize the overall amplifier performance for a certain criterion like gain, bandwidth, efficiency, output power capability or linearity, and to make the parallel amplifier multi-band capable.

The novel features of the invention are as follows:
1. Reconfigurable circuits at the inputs and/or outputs of the active amplifying devices of the parallel amplifier.
2. Parallel amplifier design without the need for power-consuming combining or splitting networks like baluns, hybrids, power splitter and power combiners.
3. No change in the parallel amplifier's performance when switching on or off different branches.
4. Possibility to scale the output power capability to the need of the special application by powering on or off different branches of the parallel amplifier and by using not identical active devices.
5. With the possibility to use not identical active devices, a multi input and/or output transistor with different numbers of fingers per active device can be designed to fit the defined output power characteristic of a certain application.
6. With the possibility to power on or off different branches, one can achieve an efficiency enhancement for reduced output power levels. Figure 6 shows the principle efficiency enhancement for a two branch parallel amplifier with equal active devices. As both active devices are equal, a step in efficiency occurs at 3 dB power back off.
7. The reconfigurable circuits can be used to optimize the amplifier's performance for a certain criterion.
8. Effectiveness of the parallel amplifier does not depend anymore on symmetries in the design or tolerances of the components.
9. With the reconfigurable circuits at the inputs and outputs of the active devices, the ability to optimize the parallel amplifier's performance for a certain criterion like maximum gain, maximum efficiency, maximum output power capability, lowest distorsion measured, i. e. adjacent channel protection ratio, ACPR or whatever is needed, and the multiband capability comes almost for free.
10. No symmetry of the branches is necessary, so one can use active devices with different behaviour, e. g. different output power capabilities to be able to design an output power capability scaling for the parallel amplifier that is adapted to the needs of the special application.
11. The effectiveness of the parallel amplifier concept does not depend anymore on any symmetry in the design or on tolerances of the components.
12. The performance of the parallel amplifier does not depend anymore on the number of powered on active devices.
13. The reconfigurable circuits give raise to the possibility of building adaptive circuits around the different active devices to be able to compensate for drift phenomena caused by temperature or aging without the need for any kind of manual retuning of the parallel amplifier.
14. Fixed input and output networks around the active devices force many compromises in the RF design and achievable performance of the amplifier. With reconfigurable circuits one gains a lot more flexibility.
15. As the combining and splitting networks causing additional power losses can be omitted, the efficiency of the reconfigurable parallel amplifiers raises disregarding the losses in the reconfigurable circuits which are lower.
16. The Doherty concept and other concepts using parallel amplifiers are closer to realization by using reconfigurable circuits at the input and/or output of the active devices.

## Claims

1. An amplifier arrangement, comprising
signal input means (3);
a first amplifying device (1) having a first input and a first output;
at least a second amplifying device (2) having a second input and a second output; and
a signal output means (4);
wherein said signal input means (3) is adapted to split and/or condition any incoming signal into at least a first branch (11) and a second branch (12),
said first branch (11) being connected to said first input of said first amplifying device (1), and
said second branch (12) being connected to said second input of said second amplifying device (2), and
wherein said signal output means (4) is adapted to combine any signal output from said first and second outputs;
**characterized in that**
said signal input means (3) includes at least one reconfigurable circuit (31, 32, 36) to said first and second amplifying devices (1, 2), said signal output means (4) includes at least one reconfigurable circuit (33, 34, 35),
and **in that**
control means (5) for said reconfigurable circuits (31 through 36) is provided for controlling said reconfigurable circuits individually and independently from one another.

2. The amplifier arrangement according to claim 1, further comprising bias control means (6) and wherein each said first amplifying means (1) and said second amplifying means (2) is provided with a variable gain factor.

3. The amplifier arrangement according to claim 2, wherein operation control means (7) is provided for controlling said control means (5) for the reconfigurable circuits (31 through 36) and for controlling said bias control means (6).

4. The amplifier arrangement according to claim 2 or 3, wherein said bias control means (6) is a DC bias control means for determining DC bias of the respective amplifying device (1, 2).

5. The amplifier arrangement according to one of claims 1 through 4, wherein said signal input means (3) includes a first branch (11) and a second branch (12), each including a respective reconfigurable circuit (31, 32).

6. The amplifier arrangement according to one of claims 1 through 5, wherein said signal output means (4) includes a third branch (13) and a fourth branch (14), each including a respective reconfigurable circuit (33, 34).

7. The amplifier arrangement according to one of claims 1 through 6, wherein said amplifying devices (1, 2) are implemented by several single packaged transistors.

8. The amplifier arrangement according to one of claims 1 through 6, wherein said amplifying devices (1, 2) are implemented by a transistor array.

9. The amplifier arrangement according to one of claims 1 through 6, wherein said amplifying devices (1, 2) are implemented by at least one ladder transistor (8) having a plurality of input pins (81, 82, 83) and at least one output pin (87).

10. The amplifier arrangement according to claim 9, wherein said ladder transistor (8) comprises a plurality of sections, each forming an active and separate controllable device.

11. The amplifier arrangement according to one of claims 1 through 10, wherein said reconfigurable circuits (31 through 36) comprise RF-MEMS switches and/or varactors.
